Europäisches Patentamt

European Patent Office

Office européen des brevets

(19)

(11) Numéro de publication: **0 108 662**

**A1**

(12) # DEMANDE DE BREVET EUROPEEN

(21) Numéro de dépôt: **83401923.4**

(22) Date de dépôt: **30.09.83**

(51) Int. Cl.³: **H 02 M 1/08**
    **H 02 M 3/155**

(30) Priorité: **04.10.82 FR 8216592**

(43) Date de publication de la demande:
    **16.05.84 Bulletin 84/20**

(84) Etats contractants désignés:
    **DE GB IT SE**

(71) Demandeur: **PRECISION MECANIQUE LABINAL Société Anonyme:**
    **5 Avenue Newton Parc d'activités**
    **F-78390 Bois d'Arcy(FR)**

(72) Inventeur: **Gosselin, Olivier Lionel**
    **1 avenue de la Porte de Sèvres**
    **F-75015 Paris(FR)**

(72) Inventeur: **Escalon, Didier Marc**
    **12 rue Jules Auffrey**
    **F-93330 Neuilly Sur Marne(FR)**

(74) Mandataire: **Lemoine, Michel et al,**
    **Cabinet Michel Lemoine 13, boulevard des Batignolles**
    **F-75008 Paris(FR)**

(54) **Circuit de commande de base d'un transistor de puissance.**

(57) Le circuit de commande de la base du transistor de puissance ($T_p$) comporte une dérivation de la ligne d'alimentation passant par un transistor de commande (T1) susceptible de permettre et d'interrompre le passage du courant pour aboutir à l'entrée d'une self (L) dont la sortie est reliée à la base du transistor de puissance ($T_p$), une diode (D) permettant le passage du courant de décharge de la self. Cette commande consomme une puissance particulièrement faible.

Fig 1

EP 0 108 662 A1

Circuit de commande de base d'un transistor de puissance.

------------------------------------------------------

La présente invention a trait à un circuit de
commande de base d'un transistor de puissance tel que
par exemple un transistor de commande d'une alimentation,
d'un moteur, d'un dispositif à actionnement périodique etc.

D'une façon usuelle, un circuit de commande d'un
transistor de puissance comporte un transistor de commande
relié, d'une part, à la ligne d'alimentation de puissance
et d'autre part, à la base du transistor de puissance par
l'intermédiaire d'une résistance, la base du transistor
de commande étant soumise à l'action de moyens de commande
quelconques. Si l'on tient compte de la valeur de la résistance nécessaire et de l'intensité traversant le transistor
de commande et la résistance, qui peut atteindre facilement
le 10ème de l'intensité traversant le transistor de puissance, on se rend compte que la consommation d'un tel
circuit dépasse notablement la consommation inhérente
au transistor de puissance lui-même, de sorte que
l'ensemble d'une telle alimentation entraîne une perte
de puissance non négligeable et par conséquent, une grande consommation
d'énergie. Cette énergie est, de plus, transformée en chaleur, ce qui nécessite la présence de moyens d'évacuation de chaleur encombrants et onéreux.

On peut envisager de diminuer la consommation en remplaçant un tel circuit de commande par une alimentation séparée dont la tension est adaptée à la commande de la base du transistor de puissance. Cependant, une alimentation séparée est relativement complexe et onéreuse de sorte que la diminution de consommation est, au moins en partie, compensée par un accroissement du prix de revient. Une autre solution consiste à utiliser un circuit Darlington qui diminue également la perte d'énergie au niveau du transistor mais présente l'inconvénient d'augmenter la perte en ligne. Il est donc souhaitable de pouvoir disposer d'un circuit de commande de transistor de puissance qui remédie à ces inconvénients et l'invention a donc pour but de fournir un tel circuit qui soit extrêmement simple et économique, qui ne consomme qu'une quantité minimale d'énergie et ne dissipe qu'une faible quantité de chaleur, tout en étant adapté à des modes de commande variés.

L'invention a donc pour objet un circuit de commande d'un transistor de puissance comprenant des moyens disposés en dérivation sur la ligne d'alimentation pour piloter la base du transistor de puissance, caractérisé en ce que la dérivation de la ligne d'alimentation passe par un transistor de commande susceptible de permettre et d'interrompre le passage du courant pour aboutir à l'entrée d'une self dont la sortie est reliée à la base du transistor de puissance, l'entrée de la self étant par ailleurs liée à une diode montée en opposition et reliée à la ligne de retour.

Ainsi, conformément à l'invention, lorsqu'en agissant sur la base du transistor de commande, on rend celui-ci conducteur, la self est alimentée et la base du transistor de puissance se trouve amenée à un

3

potentiel permettant de rendre celui-ci conducteur.

Lorsque l'intensité traversant le transistor de puissance sera suffisante, on peut bloquer le transistor de commande, le courant de décharge de la self, dont la diode assure la continuité, maintenant le transistor de puissance conducteur pendant une durée supplémentaire suffisamment longue, après quoi l'on rend à nouveau conducteur le transistor de puissance et ainsi de suite.

Il est ainsi possible, tout en utilisant des éléments ne consommant qu'une énergie extrêmement faible, d'afficher, sur la base du transistor de puissance, les valeurs de tension permettant son bon fonctionnement.

Bien entendu, la self est conçue pour avoir une résistance faible mais on préférera utiliser une self de grande inductance. Dans ce cas, pour permettre un bon fonctionnement du circuit malgré la constante de temps très importante de la self, on peut, selon une caractéristique particulièrement avantageuse de l'invention, relier la sortie de la self, et donc la base du transistor de puissance, à la ligne de retour par l'intermédiaire d'un transistor auxiliaire qui est bloqué lorsque l'on débloque le transistor de commande et qui est débloqué lorsqu'on bloque ce dernier.

La commande de la base du transistor de commande peut être assurée par différents moyens en fonction des conditions et des avantages d'utilisation recherchés.

Ainsi dans un premier mode de mise en oeuvre de l'invention, on peut mesurer l'intensité de commande, c'est-à-dire l'intensité traversant la self, et d'autre part, l'intensité du circuit de puissance, et bloquer le transistor de commande en fonction de la valeur du rapport de ces intensités avec une hystérésis sur l'intensité traversant la self.

Dans un autre mode de mise en oeuvre, on peut mesurer la tension de saturation du transistor de puissance et la comparer à une valeur fixe avec hystérésis sur le comparateur pour piloter le transistor de commande en fonction de cette tension de saturation.

Dans un autre mode de mise en oeuvre, on peut également piloter la base du transistor de commande par des moyens de séquencement extérieurs.

D'autres avantages et caractéristiques de l'invention apparaîtront à la lecture de la description suivante, faite à titre d'exemple non limitatif et se référant aux dessins annexés dans lesquels :

- La figure 1 représente un schéma d'un circuit selon l'invention ;
- Les figures 2 à 4 représentent ce circuit avec différents moyens d'actionnement du transistor de commande ;
- La figure 5 représente le chronogramme des principaux signaux observés lors du fonctionnement du circuit de la figure 1.

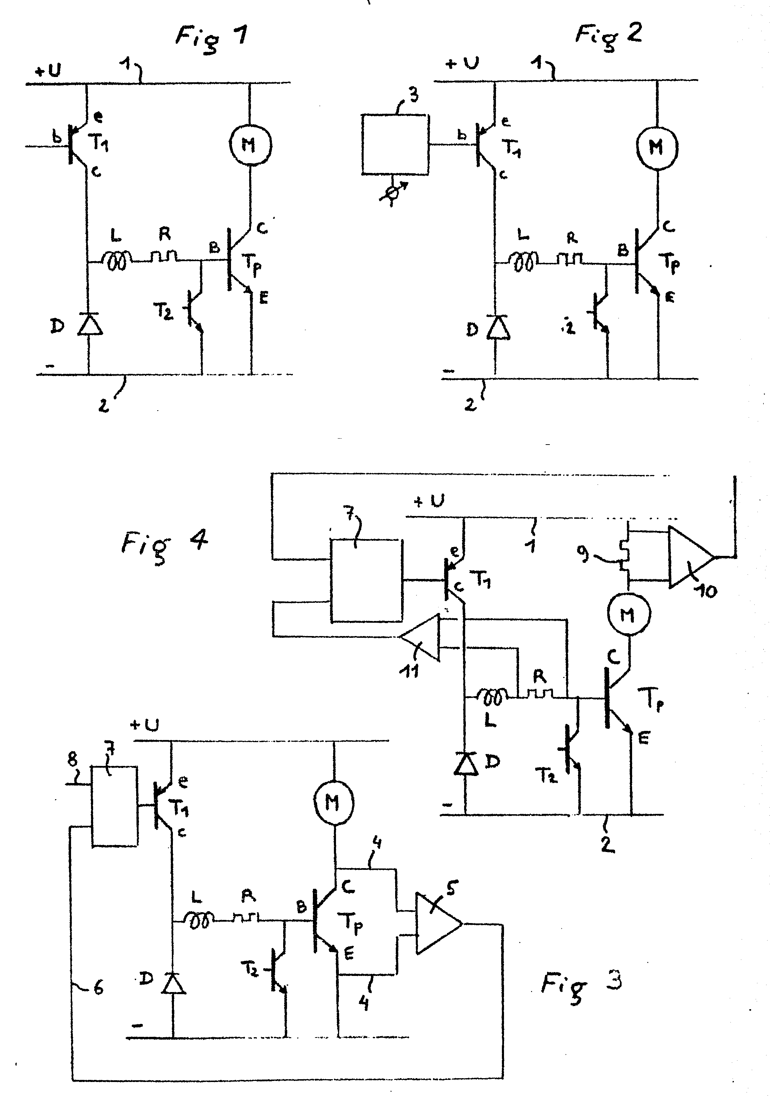

En se référant à la figure 1, on voit un circuit selon l'invention disposé entre les deux conducteurs 1 et 2 soumis à une différence de potentiel + U, l'alimentation s'effectuant à l'aide d'un générateur ou d'une source quelconque (non représenté). Entre les lignes 1 et 2 se trouve connectée une charge M, par exemple un moteur à courant continu relié au collecteur C d'un transistor de puissance $T_p$ dont l'émetteur E est relié à la ligne 2.

La ligne 1 est reliée d'autre part à l'émetteur e d'un transistor de commande T1 dont le collecteur c est relié à l'entrée d'une self L dont la sortie est reliée à une résistance R, elle-même aboutissant à la base B du transistor de puissance $T_p$. La résistance R possède une valeur faible et peut être éventuellement constituée par la résistance intérieure de la self L. Entre d'une part le collecteur c de T1 et la self L, et d'autre part la ligne 2 se trouve interposée une diode D montée pour assurer la continuité du courant de décharge de la self L. Enfin la base B du transistor de puissance $T_p$ est reliée à la ligne 2 par l'intermédiaire d'un transistor T2 dont la base peut être pilotée par tout moyen connu.

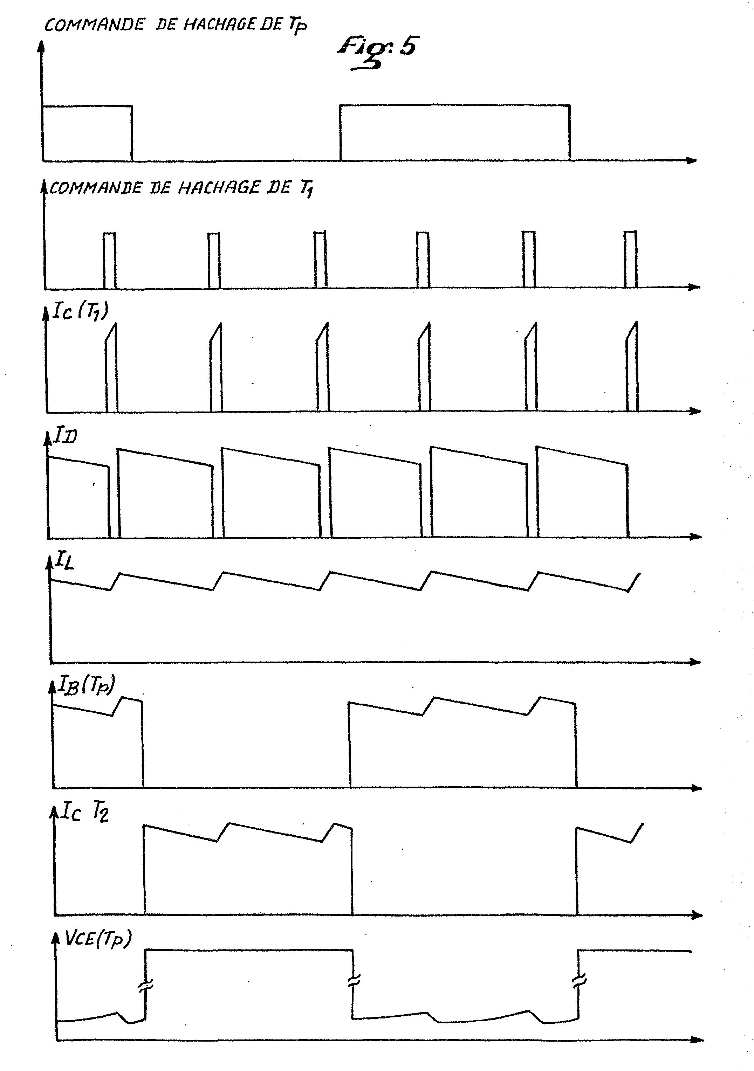

Le fonctionnement du circuit sera bien compris en se reportant à la figure 5.

Pour commander le transistor de puissance $T_p$ , on allume le transistor de commande T1, le transistor T2 étant bloqué. On voit sur le schéma II de la figure 5 les signaux établis sur la base b du transistor T1 et qui assurent les allumages successifs de T1. Lorsque T1 est allumé, l'intensité $I_c$ sur le collecteur c croît linéairement comme on le voit sur la figure III, la pente étant déterminée par les valeurs de L et U. Quand le courant $I_c$ arrive à une valeur fixée à l'avance, on coupe T1 de sorte qu'il s'établit un courant de décharge de la self L par la diode D. Les signaux électriques au niveau de la diode D prendront donc l'allure représentée sur le chronogramme IV alors que le signal du courant en passant par la self prend l'allure en dents de scie représentée sur le chronogramme V, à savoir une allure en dents de scie dont les valeurs de crête sont déterminées par l' ondulation  de courant choisie  .    En d'autres termes, le courant de base $I_B$ du transistor de puissance $T_p$ possède alors une forme en dents de scie dont les valeurs de crête sont fixées par l'hystérésis.

Grâce à cette configuration, la puissance dissipée pour alimenter la base du transistor de puissance $T_p$ est minimale. Elle est en effet  égale, lors de la conduction du transistor de commande T1, à :

$$V_{ce}I_B + RI^2_B + V_{BE}(T_p)I_B.$$

Lorsque T1 est éteint, elle est égale à :

$$RI^2_B + V_{BE}I_B + V_DI_B \, ,$$

$V_{ce}$ représentant le potentiel collecteur-émetteur du transistor T1, $V_{BE}$ représentant le potentiel base-émetteur du transistor de puissance, et $V_D$ représentant le potentiel de diode. Comme cela a déjà été précisé, R peut être de très faible valeur et peut même être constituée par la résistance propre de la self L.

Conformément à l'invention, la commande de la base du transistor de commande T1 peut être effectuée de différentes manières.

Par exemple en se référant à la figure 2, on voit que la base de T1 peut être commandée a priori par un modulateur 3, réglable ou non, qui impose une fréquence déterminée, réglable ou non, à T1 et un rapport cyclique, réglable ou non, de conduction et de blocage à T1, les valeurs choisies déterminant une valeur moyenne et un lissage déterminé du courant de base $I_B$.

En se référant à la figure 3, on voit une commande de transistor T1 par un fonctionnement à hystérésis de la tension de saturation $V_{CE}$ collecteur-émetteur du transistor de puissance. Ainsi on détecte, par les conducteurs 4, les valeurs des tensions collecteur-émetteur du transistor de puissance $T_p$ pour adresser ces signaux par l'intermédiaire d'un amplificateur 5, d'un conducteur 6 et d'un comparateur 7 sur lequel on peut également afficher en 8 la référence de la tension de saturation collecteur-émetteur.

En se référant à la figure 4, on voit un fonctionnement à gain constant sur le transistor de puissance dans lequel on fait une mesure de courant collecteur du transistor $T_p$ par le biais d'une résistance de mesure 9 et d'un amplificateur opérationnel 10, on divise ce courant par le gain choisi et on le compare dans un comparateur 7 à la mesure du courant de base $I_B$ du transistor de puissance $T_p$, par exemple à l'aide d'une mesure aux bornes de la résistance R par l'intermédiaire d'un amplificateur opérationnel 11. En fixant une hystérésis au niveau de la comparaison, on commande l'allumage ou l'extinction de T1 pour obtenir un gain constant sur le transistor $T_p$.

7

Pour le hachage du courant collecteur du transistor de puissance $T_p$, c'est-à-dire en d'autres termes pour la commande de fonctionnement de la charge M, on peut agir de deux façons.

Ainsi on peut éteindre le transistor T1 et attendre que la self L soit déchargée. Dans ce cas, si l'on veut une exécution rapide des instructions de commande, il faut une constante de temps L/R faible, ce qui n'est pas favorable car la fréquence de hachage au niveau du transistor de commande de T1 devient alors très importante, voire excessive, pour une hystérésis donnée. Dans ce cas, le transistor auxiliaire T2 est inutile et est donc supprimé.

Selon la deuxième variante, on peut adopter une constante de temps L/R élevée, et dériver le courant par un transistor auxiliaire T2. La base de celui-ci est pilotée de toute façon convenable, par exemple par un asservissement ou tout autre moyen de commande. On peut ainsi obtenir sans problème des fréquences de hachage très élevées sur le courant collecteur du transistor de puissance $T_p$.

A titre d'exemple, l'utilisation d'un circuit de commande selon l'invention permet de réduire de 10 à 100 fois la puissance dissipée dans un circuit de commande classique lorsque l'on veut utiliser le transistor de puissance seul en ligne (c'est-à-dire sans montage Darlington).

Bien que l'invention ait été décrite à propos d'une forme de réalisation particulière, il est bien entendu qu'elle n'y est nullement limitée et qu'on peut lui apporter diverses modifications de forme sans pour cela s'éloigner ni de son cadre ni de son esprit.

REVENDICATIONS

1.- Circuit de commande d'un transistor de puissance ($T_p$) comprenant des moyens disposés en dérivation sur la ligne d'alimentation pour piloter la base (B) du transistor de puissance ($T_p$), caractérisé en ce que la dérivation de la ligne d'alimentation passe par un transistor de commande (T1) susceptible de permettre et d'interrompre le passage du courant pour aboutir à l'entrée d'une self (L) dont la sortie est reliée à la base (B) du transistor de puissance ($T_p$), l'entrée de la self étant par ailleurs liée à une diode (D) montée en opposition et reliée à la ligne de retour.

2.- Circuit selon la revendication 1, caractérisé en ce que la dérivation comporte, en plus de la résistance interne faible de la self (L), une résistance auxiliaire (R) interposée entre la self et la base (B) du transistor de puissance ($T_p$).

3.- Circuit selon l'une quelconque des revendications 1 et 2, caractérisé en ce que, pour successivement permettre et interrompre le passage du courant, la base (b) du transistor de commande (T1) est commandée par un modulateur (3) imposant une fréquence déterminée et un rapport cyclique déterminé.

4.- Circuit selon l'une quelconque des revendications 1 et 2, caractérisé en ce que, pour successivement permettre et interrompre le passage du courant dans le transistor de commande (T1), on détecte les valeurs des tensions collecteur-émetteur du transistor de puissance ($T_p$) pour le fonctionnement hystérésis de la tension de saturation collecteur-émetteur.

5.- Circuit selon l'une quelconque des revendications 1 et 2, caractérisé en ce que, pour successivement permettre et interrompre le passage du courant dans le transistor de commande (T1), on effectue une mesure du courant collecteur du transistor de puissance ($T_p$) par le biais d'une résistance de mesure (9), on divise ce courant par le gain choisi et on le compare dans un comparateur (7) à la mesure du courant de base ($I_B$) du transistor ($T_p$) également mesuré, en fixant une hystérésis au niveau de la comparaison.

6.- Circuit selon l'une quelconque des revendications 1 à 5, caractérisé en ce que, pour hacher le courant collecteur du transistor de puissance ($T_p$), on éteint le transistor (T1) et on attend que la self (L) se décharge.

7.- Circuit selon l'une quelconque des revendications 1 à 5, caractérisé en ce que, pour hacher le courant collecteur du transistor de puissance ($T_p$), un transistor auxiliaire (T2) est interposé entre la base (B) du transistor de puissance ($T_p$) et la ligne de retour (2), la base dudit transistor auxiliaire étant pilotée de façon convenable pour dériver à volonté le courant passant par la self (L).

Fig 1

Fig 2

Fig 4

Fig 3

2/2

0108662

Fig. 5

0108662

Numéro de la demande

Office européen
des brevets

**RAPPORT DE RECHERCHE EUROPEENNE**

EP  83 40 1923

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | EP-A-0 030 855  (WESTINGHOUSE) * Page 4, ligne 29 - page 17, ligne 6 * | 1,3,7 | H 02 M  1/08 H 02 M  3/155 |
| A | DE-A-2 332 887  (BOEHRINGER) * Page 4, ligne 22 - page 19, ligne 23 * | 1 | |
| A | FR-A-2 200 668  (WESTINGHOUSE) * Figure 1 * | 4 | |

DOMAINES TECHNIQUES RECHERCHES (Int. Cl. ³)

H 02 M  1/00
H 02 M  3/00

Le présent rapport de recherche a été établi pour toutes les revendications

| Lieu de la recherche LA HAYE | Date d'achèvement de la recherche 09-01-1984 | Examinateur BERTIN M.H.J. |
|---|---|---|